# EUROPÄISCHE PATENTANMELDUNG

(11) **EP 1 031 985 A2**
(43) Veröffentlichungstag der Anmeldung: **30.08.2000**
(21) Anmeldenummer: 00103877.7
(22) Anmeldetag: 24.02.2000
(51) Int. Cl.: G11C 5/14, G11C 8/00, G11C 11/408

(54) **Integrierter Speicher**

(30) Priorität: 25.02.1999 DE 19908205
(71) Anmelder: Infineon Technologies AG, 81541 München (DE)
(72) Erfinder: Schlager, Tobias, 8010 Graz (AT); Hönigschmid, Heinz, 82319 Starnberg (DE); Braun, Georg, 80339 München (DE); B-hm, Thomas, 85604 Zorneding (DE)
(74) Vertreter: Zedlitz, Peter, Dipl.-Ing.

(57) **Zusammenfassung**

In einer ersten Verdrahtungsebene (M1) des Speichers verlaufen parallele Leiterbahnen (M11, M12). In einer zweiten Verdrahtungsebene des Speichers verlaufen Segmente (GL) parallel zu den Leiterbahnen (M11, M12). Wortleitungen (WL) sind jeweils durch eine Leiterbahn eines ersten Typs (M11) sowie durch die parallel zu dieser Leiterbahn angeordneten Segmente (GL) gebildet. Eine Leiterbahn eines zweiten Typs (M12) ist einerseits mit einer ersten Versorgungsleitung (V_{PW}) und andererseits mit in einer dritten Verdrahtungsebene innerhalb des Zellenfeldes angeordneten Bereichen (p⁺ ; PL) verbunden.

## Beschreibung

Die Erfindung betrifft einen integrierten Speicher.

Integrierte Speicher, wie beispielsweise DRAMs (Dynamic Random Access Memories), weisen in der Regel eine Vielzahl von Speicherzellen auf, die in Kreuzungspunkten von Wortleitungen und Bitleitungen angeordnet sind. Die Wortleitungen und Bitleitungen sind dabei jeweils parallel zueinander angeordnet und weisen zueinander regelmäßige Abstände auf. Die Anordnung der Speicherzellen entlang der Wortleitungen und Bitleitungen wird auch als Speicherzellenfeld bezeichnet. Oft ist es notwendig, Bereichen innerhalb des Zellenfeldes bestimmte Potentiale bzw. Signale zuzuführen. Diese Potentiale können mittels Leitungen, die außerhalb des Zellenfeldes parallel zu einer der Kanten des Zellenfeldes verlaufen, zugeführt werden, wobei sich diese Leitungen nach innerhalb des Zellenfeldes verzweigen, wo sie mit den Bereichen verbunden sind, denen das jeweilige Potential zuzuführen ist. Hierbei ergibt sich folgendes Problem: Je größer die Ausdehnung des Zellenfeldes ist - seine Ausdehnung nimmt mit höheren Speicherkapazitäten zu - , desto länger werden die für die Führung der Potentiale notwendigen relativ schlecht leitenden Verzweigungsleitungen innerhalb des Zellenfeldes, die von den entlang des Zellenfeldes geführten (Haupt-) Versorgungsleitungen abzweigen. Als Folge der zunehmenden Leitungslängen ergibt sich ein erhöhter Leitungswiderstand, der bewirkt, daß die zuzuführenden Potentiale anfällig für Störungen sind, die beispielsweise durch Schwankungen des Versorgungspotentials ausgelöst werden.

Es wäre daher wünschenswert, die für die zur Zuführung der Potentiale zu den zu versorgenden Bereichen notwendigen Hauptversorgungsleitungen nicht nur am Rande des Zellenfeldes, sondern auch inmitten des Zellenfeldes zu führen, um die beschriebenen schlechter leitenden Verzweigungsleitungen zu vermeiden beziehungsweise möglichst kurz zu halten. Dem steht jedoch entgegen, daß die Strukturen, die die Bitleitungen und Wortleitungen bilden, sowie die Strukturen, die die in den Kreuzungspunkten von Wort- und Bitleitungen angeordneten Speicherzellen bilden, möglichst regelmäßig angeordnet werden sollten, um einen optimierten Fertigungsprozeß zu erzielen. Da außerdem zur Erzielung möglichst kompakter Speicherzellenfelder die Abstände zwischen den Wortleitungen und zwischen den Bitleitungen jeweils zu minimieren sind, ist es nicht möglich, die Versorgungsleitungen ohne den Einsatz weiterer Verdrahtungsebenen inmitten des Speicherzellenfeldes zu führen, ohne daß die regelmäßige Struktur der Wort- und Bitleitungen an diesen Stellen unterbrochen wird.

Der Erfindung liegt die Aufgabe zugrunde, einen integrierten Speicher der beschriebenen Art anzugeben, dessen Herstellung durch die regelmäßige Anordnung der die Wortleitungen, Bitleitungen und Speicherzellen bildenden Strukturen begünstigt ist und bei dem trotzdem die Zuführung bestimmter Potentiale mitten in das Zellenfeld auf eine Weise erfolgt, bei der der Widerstand entsprechender Versorgungsleitungen ohne zusätzliche Verdrahtungsebenen möglichst gering gehalten wird.

Diese Aufgabe wird mit einem integrierten Speicher gemäß Patentanspruch 1 gelöst. Vorteilhafte Aus- und Weiterbildungen der Erfindung sind Gegenstand abhängiger Ansprüche.

Der integrierte Speicher hat Speicherzellen, die in einem Speicherzellenfeld in Kreuzungspunkten von Bitleitungen und Wortleitungen angeordnet sind und die jeweils einen Auswahltransistor aufweisen, der die Speicherzelle mit einer der Bitleitungen verbindet und der einen Steueranschluß hat, der mit einer der Wortleitungen verbunden ist. Er hat weiterhin eine Wortleitungsdecoder mit Ausgängen, die mit je einer der Wortleitungen verbunden sind, sowie eine erste Versorgungsleitung für ein erstes Potential. Der Speicher weist innerhalb des Zellenfeldes in einer ersten Verdrahtungsebene regelmäßig angeordnete und parallel zueinander verlaufende Leiterbahnen sowie in einer zweiten Verdrahtungsebene regelmäßig angeordnete Segmente auf, von denen jeweils mehrere parallel zu jeder Leiterbahn angeordnet sind. Die Segmente sind jeweils mit den Steueranschlüssen der Auswahltransistoren einer Vielzahl der Speicherzellen verbunden. Die Leiterbahnen sind in einer Vielzahl von Leiterbahnen eines ersten Typs und wenigstens eine Leiterbahn eines zweiten Typs unterteilt. Die Wortleitungen sind jeweils durch eine der Leiterbahnen des ersten Typs sowie durch die parallel zu dieser Leiterbahn angeordneten Segmente gebildet, wobei jede Leiterbahn des ersten Typs einerseits mit einem der Ausgänge des Wortleitungsdecoders und andererseits mit den parallel zu ihr angeordneten Segmenten verbunden ist. Die Leiterbahn des zweiten Typs ist einerseits mit der ersten Versorgungsleitung und andererseits mit einem in einer dritten Verdrahtungsebene innerhalb des Zellenfeldes angeordneten Bereich verbunden.

Die Erfindung beruht auf der Idee, daß sowohl die Leiterbahn des zweiten Typs, die zur Versorgung des in der dritten Verdrahtungsebene angeordneten Bereiches mit dem ersten Potential dient, als auch die Wortleitungen als ihren Bestandteil die regelmäßig angeordneten und parallel zueinander verlaufenden Leiterbahnen aufweisen. Dies ermöglicht den Aufbau eines regelmäßigen Zellenfeldes, dessen Herstellungsprozeß relativ problemlos ist. Bei gewöhnlichen Speichern würde jede der Leiterbahnen Bestandteil einer der Wortleitungen sein. Beim erfindungsgemäßen Speicher sind die Leiterbahnen des zweiten Typs jedoch kein Bestandteil einer Wortleitung, sondern dienen der Führung des ersten Potentials zum zu versorgenden Bereich.

Als in der dritten Verdrahtungsebene angeordneter Bereich kommt beispielsweise eine in einem Substrat des integrierten Speichers angeordnete dotierte Wanne in Frage. Wenn die Speicherzellen des Speichers je einen Speicherkondensator aufweisen, wie dies beispielsweise bei DRAMs der Fall ist, kann der in der dritten Verdrahtungsebene angeordnete Bereich auch eine Zellplatte sein, die mit einer der Elektroden jedes der Speicherkondensatoren verbunden ist.

Nach einer Weiterbildung der Erfindung weist der integrierte Speicher eine zweite Versorgungsleitung für ein zweites Potential auf, das bei Anliegen am Steueranschluß eines der Auswahltransistoren diesen sperrt. Eine der Leiterbahnen, die benachbart zur Leiterbahn des zweiten Typs angeordnet ist, ist eine Leiterbahn eines dritten Typs, die einerseits mit der zweiten Versorgungsleitung und andererseits mit den parallel zu ihr angeordneten Segmenten verbunden ist. Die mit der Leiterbahn des dritten Typs verbundenen Segmente sind in der zweiten Verdrahtungsebene mit denjenigen Segmenten verbunden, die parallel zur Leiterbahn des zweiten Typs angeordnet sind.

Diese Weiterbildung hat den Vorteil, daß die parallel zur Leiterbahn des zweiten Typs angeordneten Segmente ebenfalls mit dem zweiten Potential versorgt werden, so daß die mit ihnen verbundenen Auswahltransistoren ständig gesperrt sind und die zugehörigen Speicherzellen das Potential auf den mit ihnen verbundenen Bitleitungen nicht beinflussen.

Die Erfindung wird im folgenden anhand der Figuren näher erläutert, die Ausführungsbeispiele zeigen. Es zeigen:
- Figur 1: eine Prinzipdarstellung des Speicherzellenfeldes des erfindungsgemäßen integrierten Speichers,
- Figur 2: den integrierten Speicher aus Figur 1 in einer Layout-Darstellung in Draufsicht,
- die Figuren 3 bis 5: Querschnittdarstellungen des in Figur 2 dargestellten Speichers an verschiedenen Kontaktierungsstellen und
- Figur 6: eine Speicherzelle des in den vorangegangenen Figuren dargestellten Speichers.

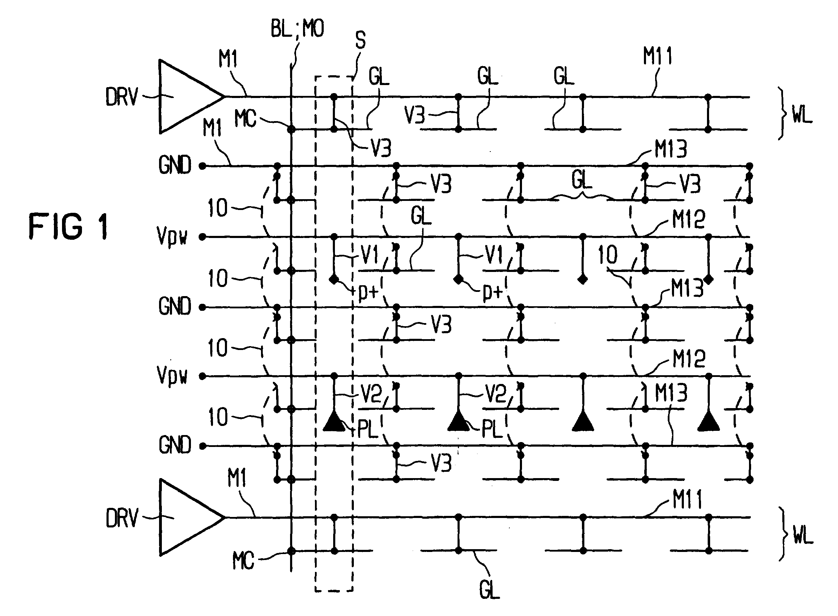

Figur 1 zeigt einen Ausschnitt eines Speicherzellenfeldes eines erfindungsgemäßen integrierten Speichers vom Typ DRAM. Die Speicherzellen MC sind in Kreuzungspunkten von Bitleitungen und Wortleitungen WL angeordnet. Von den Bitleitungen BL ist in Figur 1 nur eine ausschnittsweise dargestellt. In Wirklichkeit weist der Speicher eine Vielzahl dieser Bitleitungen auf, die jeweils parallel zueinander angeordnet sind. Die Bitleitungen BL verlaufen in einer ersten Metallisierungsebene M0 des Speichers. Von den Wortleitungen WL sind in Figur 1 lediglich zwei, nämlich am oberen und am unteren Rand der Figur, dargestellt. In Wirklichkeit weist der Speicher eine große Anzahl weiterer Wortleitungen auf, die jeweils horizontal verlaufen und oben und unten benachbart zu den beiden in Figur 1 dargestellten Wortleitungen WL angeordnet sind. In Figur 1 sind nur die entlang der einzigen eingezeichneten Bitleitung BL angeordneten Speicherzellen MC als Kreise dargestellt.

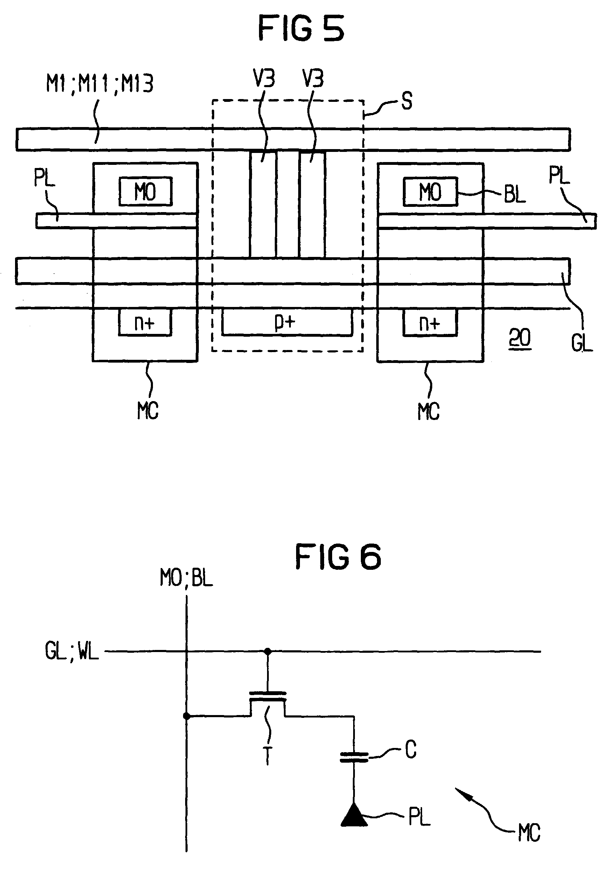

Die Speicherzellen MC haben den in Figur 6 gezeigten Aufbau einer DRAM-1-Transistor-1-Kondensator-Speicherzelle. Sie weisen je einen Auswahltransistor T und einen Speicherkondensator C auf. Der Speicherkondensator C ist einerseits mit einer Zellplatte PL und andererseits über den Auswahltransistor T mit der zugehörigen Bitleitung BL verbunden. Das Gate des Auswahltransistors T ist mit der zugehörigen Wortleitung WL verbunden. Während die Bitleitungen BL, wie bereits erwähnt, in der ersten Metallisierungsebene M0 verlaufen, weisen die Wortleitungen WL als einen Bestandteil Gateleitungen in Form von Segmenten GL auf, die in einer unterhalb der ersten Metallisierungsebene M0 verlaufenden Polysiliziumebene des Speichers angeordnet sind.

Figur 1 ist zu entnehmen, daß die Wortleitungen WL jeweils eine Leiterbahn eines ersten Typs M11, die in einer zweiten Metallisierungsebene M1 angeordnet ist, und mehrere der in der Polysiliziumebene angeordneten Segmente GL aufweisen. Die Segmente GL sind mit der zugehörigen Leiterbahn vom ersten Typ M11 durch je eine Kontaktierungsstelle V3 verbunden. Die Speicherzellen MC sind entlang der Segmente GL angeordnet, das heißt, daß eine Vielzahl der Bitleitungen BL jedes Segment GL schneidet. Die Leiterbahnen vom ersten Typ M11 sind mit je einem Ausgang DRV eines in Figur 1 nicht näher dargestellten Wortleitungsdecoders verbunden. Über den Wortleitungsdecoder beziehungsweise über seine Ausgänge DRV ist zu jedem Zeitpunkt genau eine der Wortleitungen WL adressierbar. Der zuvor beschriebene Aufbau der Wortleitungen WL mit einer Hauptwortleitung und mehreren mit dieser verbundenen Wortleitungssegmenten ist allgemein bekannt und wird auch als "Stitched Word Line" oder "Segmented Word Line^{"} bezeichnet.

Der erfindungsgemäße Speicher weist in der zweiten Metallisierungsebene M1 also eine Vielzahl paralleler Leiterbahnen M11, M12, M13 auf, denen jeweils in der Polysiliziumebene Segmente GL mit den damit verbundenen Speicherzellen MC zugeordnet sind. Im Unterschied zu herkömmlichen Speichern sind unter den Leiterbahnen neben denjenigen des ersten Typs M11 auch solche eines zweiten Typs M12 und eines dritten Typs M13, die nicht Bestandteil einer der Wortleitungen WL sind. Die Leiterbahnen vom zweiten Typ M12 sind über entsprechende Kontaktierungsstellen V1 beziehungsweise V2 nicht mit den darunter liegenden und parallel zu ihnen angeordneten Segmenten GL der Polysiliziumebene, sondern mit in einer anderen Ebene angeordneten Bereichen verbunden. Im Falle der oberen Leiterbahn vom zweiten Typ M12 in Figur 1 sind diese Bereiche p-dotierte Wannen p⁺, die über Kontaktierungsstellen V1 kontaktiert sind. Im Falle der unteren Leiterbahn vom zweiten Typ M12 in Figur 1 ist dieser Bereich eine Zellplatte PL, die an mehreren Stellen über Kontaktierungsstellen V2 kontaktiert ist. Es ist selbstverständlich auch möglich, daß der Speicher nur eine oder mehr als zwei der Leiterbahnen vom zweiten Typ M12 aufweist.

Die obere Leiterbahn vom zweiten Typ M12 in Figur 1 ist mit einer nicht näher dargestellten ersten Versorgungsleitung V_{PW} verbunden, von der der dotierten Wanne p⁺ ein entsprechendes Versorgungspotential zugeführt wird. Die in Figur 1 unten dargestellte Leiterbahn vom zweiten Typ M12 ist mit einer nicht näher dargestellten weiteren Versorgungsleitung V_{PL} verbunden, über die der Zellplatte PL ein Zellplattenpotential zugeführt wird, dessen Wert von der Art des Speichers abhängt. Der Anschluß an die dotierten Wannen p⁺ ist in Figur 1 durch eine Raute und der Anschluß an die Zellplatte PL durch ein Dreieck dargestellt.

Die in Figur 1 dargestellten Leiterbahnen vom dritten Typ M13 sind zwischen je einer der Leiterbahnen vom ersten Typ M11 und einer Leiterbahn vom zweiten Typ M12 angeordnet. Die Leiterbahnen vom dritten Typ M13 sind mit einer Masseversorgungsleitung GND, die in Figur 1 nicht näher dargestellt wurde, verbunden. Sie sind über entsprechende Kontaktierungsstelle V3 mit den parallel zu ihnen in der Polysiliziumebene angeordneten Segmenten GL verbunden. Da während des Betriebes des Speichers an den Leiterbahnen des dritten Typs M13 Massepotential anliegt, sind alle mit den entsprechenden Segmenten GL verbundenen Auswahltransistoren T gesperrt. Die mit diesen Auswahltransistoren T verbundenen Speicherzellen MC beeinflussen daher das Potential auf der zugehörigen Bitleitung BL nicht.

Die Funktion der Leiterbahnen vom dritten Typ M13 ist folgende: Die Leiterbahnen vom zweiten Typ M12 sind, wie erläutert, mit der dotierten Wanne p⁺ beziehungsweise mit der Zellplatte PL verbunden und nicht mit den parallel zu ihnen in der Polysiliziumebene angeordneten Segmenten GL. Dies ist auch der Figur 1 zu entnehmen, in der keine Verbindung zwischen den Leiterbahnen vom zweiten Typ M12 und den entsprechenden Segmenten GL eingezeichnet ist. Da die mit diesen Segmenten GL verbundenen Speicherzellen das Potential auf den Bitleitungen BL in unerwünschter Weise beeinflussen könnten, wenn ihr Potential floaten würde, ist beim hier dargestellten Ausführungsbeispiel dafür gesorgt, daß das Potential dieser Segmente GL gleich dem Massepotential GND ist. Dies ist dadurch erreicht, daß in der Polysiliziumebene die Segmente GL, die den Leiterbahnen vom dritten Typ M13 zugeordnet sind, mit den Segmenten GL, die den Leiterbahnen des zweiten Typs M12 zugeordnet sind, verbunden sind. Somit liegt das Massepotential GND über die Leiterbahnen vom dritten Typ M13 und deren Segmente GL auch an den Segmenten GL an, die parallel zu den Leiterbahnen des zweiten Typs M12 angeordnet sind. Als Folge dessen sind die damit verbundenen Speicherzellen MC dauerhaft von den mit ihnen verbundenen Bitleitungen BL abgekoppelt, da ihre Auswahltransistoren T dauerhaft gesperrt sind. Die in der Polysiliziumebene realisierte Verbindung zwischen den Segmenten GL der Leiterbahnen vom zweiten M12 und dritten M13 Typ sind in Figur 1 mit dem Bezugszeichen 10 bezeichnet.

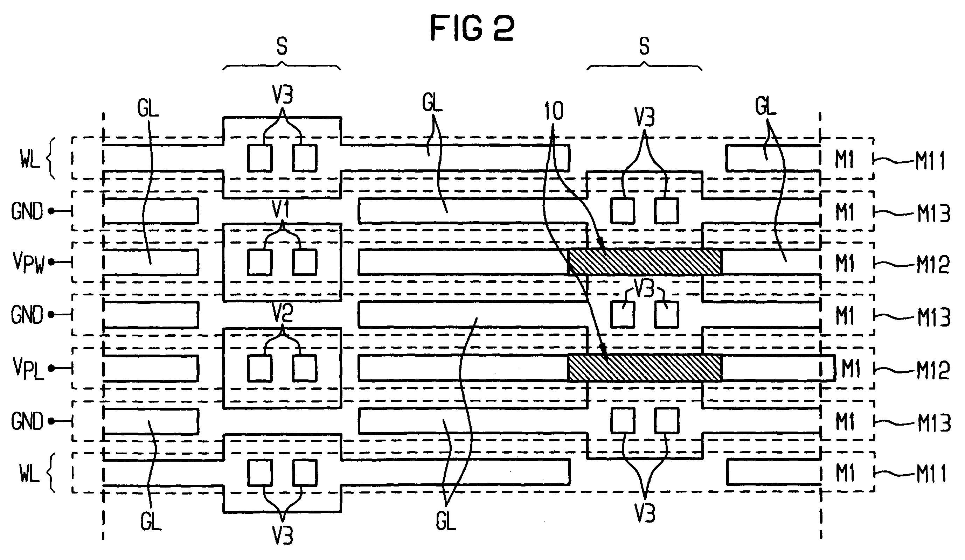

Zum besseren Verständnis zeigt Figur 2 noch einmal eine Draufsicht auf eine Layout-Darstellung des in Figur 1 ausschnittsweise dargestellten Speicherzellenfeldes. Gestrichelt dargestellt sind die in der zweiten Metallisierungsebene M1 angeordneten Leiterbahnen M11, M12, M13. In der unterhalb der zweiten Metallisierungsebene M1 befindlichen Polysiliziumebene befinden sich die Segmente GL. Figur 2 zeigt auch die verschiedenen Kontaktierungsstellen V1, V2, V3, über die die Leiterbahnen M11, M12, M13 mit den jeweils zu kontaktierenden Bereichen verbunden sind. Figur 2 zeigt auch die Polysiliziumbereiche 10, die die den Leiterbahnen vom zweiten Typ M12 und dritten Typ M13 zugeordneten Segmente GL miteinander verbinden.

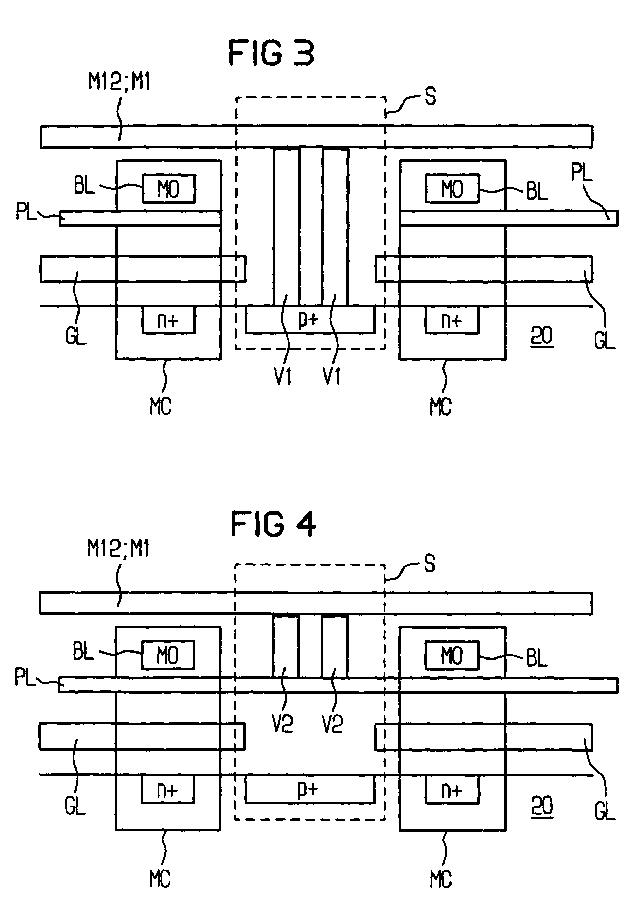

Die Figuren 3 bis 5 zeigen Schnittdarstellungen entlang horizontaler Linien in der Figur 2.

Figur 3 zeigt einen Schnitt durch eine der ersten Kontaktierungsstellen V1, über die die obere Leiterbahn vom zweiten Typ M12 in Figur 1 beziehungsweise Figur 2 mit der darunter befindlichen dotierten Wanne p⁺ verbunden ist. Dargestellt ist in der zweiten Metallisierungsebene M1 die Leiterbahn vom zweiten Typ M12. Die Bitleitungen BL verlaufen senkrecht dazu in der ersten Metallisierungsebene M0, die sich unterhalb der zweiten Metallisierungsebene M1 befindet. Die hier beschriebenen leitfähigen Ebenen beziehungsweise Verdrahtungsebenen sind jeweils durch in den Figuren nicht näher dargestellte isolierende Schichten voneinander getrennt. Unterhalb der ersten Metallisierungsebene M0 verläuft die Zellplatte PL, die aus Polysilizium besteht. In einer darunter befindlichen Ebene befindet sich die Polysiliziumebene der Segmente GL. Unterhalb der Segmente GL befindet sich ein Substrat 20 aus einem Halbleitermaterial, auf dem die zuvor geschilderten Ebenen erzeugt worden sind. Im Substrat 20 befindet sich eine der dotierten Wannen p⁺ sowie zwei n-dotierte Bereichen n⁺, die Bestandteile des Auswahltransistors T je einer der Speicherzellen MC sind. Das Substrat 20 ist beispielsweise n-dotiert.

Die ersten Kontaktierungsstellen V1 verbinden die Leiterbahn des zweiten Typs M12 mit einer Vielzahl der im Substrat 20 befindlichen dotierten Wannen p⁺.

Figur 4 zeigt die Verbindung zwischen der in Figur 1 und 2 unten dargestellten Leiterbahn vom zweiten Typ M12, die zur Zuführung des Zellplattenpotentials V_{PL} dient, über die zweiten Kontaktierungsstelle V2 mit der Zellplatte PL.

Den Figuren 3 und 4 ist zu entnehmen, daß die Leiterbahnen vom zweiten Typ M12 nicht mit den unterhalb dieser angeordneten Polysilizium-Segmenten GL verbunden sind.

Figur 5 zeigt eine der dritten Kontaktierungsstellen V3, über die die Leiterbahnen vom ersten Typ M11 und vom dritten Typ M13 mit den darunterliegenden Segmenten GL verbunden sind. Da die Figuren 4 und 5 im wesentlichen dieselben Strukturen wie Figur 3 zeigen, wird auf diese nicht noch einmal eingegangen.

Den Figuren 1 und 2 ist zu entnehmen, daß die Kontaktierungsstellen V1, V2, V3 in einem regelmäßigen Raster innerhalb des Zellenfeldes angeordnet sind. Sie sind übereinander entlang von Streifen S angeordnet, dem sogenannten "Wortleitungs-Gap". Der Wortleitungs-Gap S ist in den Figuren 1 bis 5 jeweils eingezeichnet.

Das Material der Kontaktierungsstellen V1, V2, V3 besteht bei diesem Ausführungsbeispiel, ebenso wie die erste Metallisierungsebene M0 und die zweite Metallisierungsebene M1, aus Wolfram.

## Patentansprüche

1. Integrierter Speicher
- mit Speicherzellen (MC), die in einem Speicherzellenfeld in Kreuzungspunkten von Bitleitungen (BL) und Wortleitungen (WL) angeordnet sind und die jeweils einen Auswahltransistor (T) aufweisen, der die Speicherzelle mit einer der Bitleitungen verbindet und der einen Steueranschluß hat, der mit einer der Wortleitungen verbunden ist,
- mit einem Wortleitungsdecoder mit Ausgängen (DRV), die mit je einer der Wortleitungen (WL) verbunden sind,
- mit einer ersten Versorgungsleitung (V_{PW}; V_{PL}) für ein erstes Potential,
- mit innerhalb des Zellenfeldes in einer ersten Verdrahtungsebene (M1) regelmäßig angeordneten und parallel zueinander verlaufenden Leiterbahnen (M11, M12, M13),
- mit innerhalb des Zellenfeldes in einer zweiten Verdrahtungsebene regelmäßig angeordneten Segmenten (GL), von denen jeweils mehrere parallel zu jeder Leiterbahn (M11, M12, M13) angeordnet sind,
- dessen Segmente (GL) jeweils mit den Steueranschlüssen der Auswahltransistoren (T) einer Vielzahl der Speicherzellen (MC) verbunden sind,
- dessen Leiterbahnen in eine Vielzahl von Leiterbahnen eines ersten Typs (M11) und wenigstens eine Leiterbahn eines zweiten Typs (M12) unterteilt sind,
- dessen Wortleitungen (WL) jeweils durch eine der Leiterbahnen des ersten Typs (M11) sowie durch die parallel zu dieser Leiterbahn angeordneten Segmente (GL) gebildet sind, wobei jede Leiterbahn des ersten Typs (M11) einerseits mit einem der Ausgänge (DRV) des Wortleitungsdecoders und andererseits mit den parallel zu ihr angeordneten Segmenten verbunden ist,
- und dessen Leiterbahn des zweiten Typs (M12) einerseits mit der ersten Versorgungsleitung (V_{PW}; V_{PL}) und andererseits mit einem in einer dritten Verdrahtungsebene innerhalb des Zellenfeldes angeordneten Bereich (p+; PL) verbunden ist.

2. Integrierter Speicher nach Anspruch 1,
- mit einer zweiten Versorgungsleitung (GND) für ein zweites Potential, das bei Anliegen am Steueranschluß eines der Auswahltransistoren (T) diesen sperrt,
- bei dem eine der Leiterbahnen, die benachbart zur Leiterbahn des zweiten Typs (M12) angeordnet ist, eine Leiterbahn eines dritten Typs (M13) ist, die einerseits mit der zweiten Versorgungsleitung (GND) und andererseits mit den parallel zu ihr angeordneten Segmenten (GL) verbunden ist,
- und bei dem die mit der Leiterbahn des dritten Typs (M13) verbundenen Segmente (GL) in der zweiten Verdrahtungsebene mit denjenigen Segmenten verbunden sind, die parallel zur Leiterbahn des zweiten Typs (M12) angeordnet sind.

3. Integrierter Speicher nach Anspruch 1 oder 2,
mit im Zellenfeld regelmäßig angeordneten Kontaktierungsstellen (V1, V2, V3), an denen die in der ersten Verdrahtungsebene (M11) angeordneten Leiterbahnen des ersten Typs (M1) und des dritten Typs (M13) mit den in der zweiten Verdrahtungsebene angeordneten entsprechenden Segmenten (GL) und gegebenenfalls die Leiterbahn des zweiten Typs (M12) mit dem in der dritten Verdrahtungsebene angeordneten Bereich (p+; PL) verbunden sind.

4. Integrierter Speicher nach Anspruch 1,
dessen in der dritten Verdrahtungsebene angeordneter Bereich eine in einem Substrat angeordnete dotierte Wanne (p+) ist.

5. Integrierter Speicher nach Anspruch 1,
- dessen Speicherzellen (MC) je einen Speicherkondensator (C) aufweisen
- und dessen in der dritten Verdrahtungsebene angeordneter Bereich eine Zellplatte (PL) ist, die mit einer der Elektroden jedes der Speicherkondensatoren (C) verbunden ist.
